(19) Europäisches Patentamt / European Patent Office / Office européen des brevets

(11) **EP 2 936 484 B1**

(12) **EUROPEAN PATENT SPECIFICATION**

(45) Date of publication and mention
of the grant of the patent:
**03.01.2018 Bulletin 2018/01**

(21) Application number: **14701749.5**

(22) Date of filing: **28.01.2014**

(51) Int Cl.:
**G10L 19/00** *(2013.01)*    **G10L 19/26** *(2013.01)*

(86) International application number:
**PCT/EP2014/051593**

(87) International publication number:
**WO 2014/118157 (07.08.2014 Gazette 2014/32)**

(54) **APPARATUS AND METHOD FOR PROCESSING AN ENCODED SIGNAL AND ENCODER AND METHOD FOR GENERATING AN ENCODED SIGNAL**

VORRICHTUNG UND VERFAHREN ZUR VERARBEITUNG EINES CODIERTEN SIGNALS SOWIE CODIERER UND VERFAHREN ZUR ERZEUGUNG EINES CODIERTEN SIGNALS

APPAREIL ET PROCÉDÉ POUR TRAITER UN SIGNAL CODÉ, ET CODEUR ET PROCÉDÉ POUR GÉNÉRER UN SIGNAL CODÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2013 US 201361758075 P**

(43) Date of publication of application:
**28.10.2015 Bulletin 2015/44**

(73) Proprietor: **Fraunhofer-Gesellschaft zur Förderung der angewandten Forschung e.V.
80686 München (DE)**

(72) Inventors:
• **FUCHS, Guillaume**
  **91088 Bubenrath (DE)**
• **GRILL, Bernhard**
  **90607 Rückersdorf (DE)**
• **LUTZKY, Manfred**
  **90427 Nürnberg (DE)**
• **MULTRUS, Markus**
  **90469 Nürnberg (DE)**

(74) Representative: **Zinkler, Franz
Schoppe, Zimmermann, Stöckeler
Zinkler, Schenk & Partner mbB
Patentanwälte
Radlkoferstrasse 2
81373 München (DE)**

(56) References cited:
**EP-A1- 2 116 998        WO-A1-99/38155
WO-A1-2012/000882     WO-A1-2012/110415**

• **MAX NEUENDORF (EDITOR): "WD7 of USAC", INTERNATIONAL ORGANIZATION FOR STANDARDIZATION - ORGANISATIONINTERNATIONALE DE NORMALISATION, XX, DRESDEN, GERMANY, no. ISO/IEC JTC1/SC29/WG11, MPEG21010/N11299, 26 April 2010 (2010-04-26), pages 1-148, XP002658193,**
• **BARBARA RESCH ET AL: "CE proposal on improved Bass-post filter operation for the ACELP of USAC", 93. MPEG MEETING; 26-7-2010 - 30-7-2010; GENEVA; (MOTION PICTURE EXPERT GROUP OR ISO/IEC JTC1/SC29/WG11),, no. M17831, 22 July 2010 (2010-07-22), XP030046421,**

**Description**

The present invention is related to audio signal processing and particularly to audio signal processing in the context of speech coding using adaptive bass post-filters.

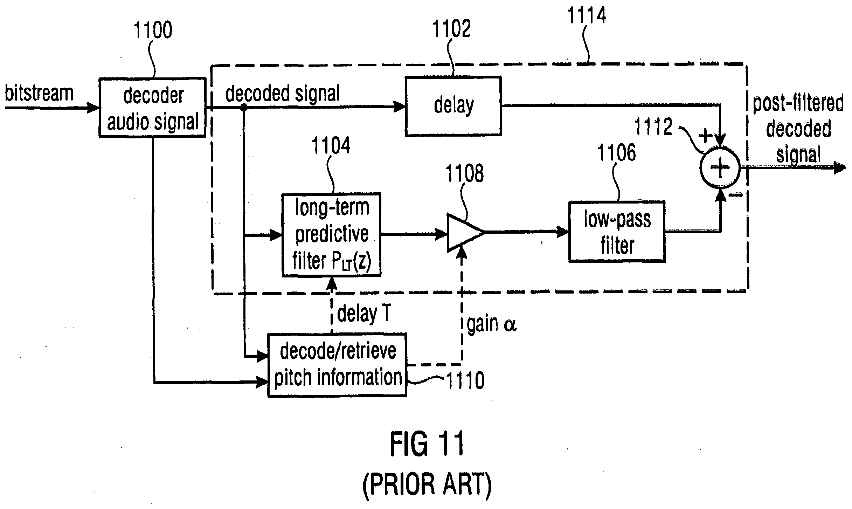

Bass post-filter is a post-processing of the decoded signal used in some speech coders. The post-processing is illustrated in Fig. 11 and is equivalent to subtracting from the decoded signal ŝ(n) a long-term prediction error which is scaled and then low-pass filtered. The transfer function of the long-term prediction filter is given by:

$$P_{LT}(z) = 1 - \frac{1}{2}z^{-T} - \frac{1}{2}z^{+T}$$

where T is a delay which usually corresponds to the pitch of the speech or the main period of the pseudo-stationary decoded signal. The delay T is usually deduced from the decoded signal or from the information contained directly within the bitstream. It is usually the long-term prediction delay parameter already used for decoding the signal. It can also be computed on the decoded signal by performing a long-term prediction analysis. The post-filtered decoded signal is then equal to:

$$\widehat{s_{pf}}(n) = \hat{s}(n) - \alpha(\hat{s}(n) * p_{LT}(n) * h_{LP}(n))$$

where $\alpha$ is a multiplicative gain corresponding to the attenuation factor of the anti-harmonic components and $h_{LP}(n)$ is the impulse response of a low-pass filter. As for the delay T, the gain can come from directly the bitstream or computed form the decoded signal.

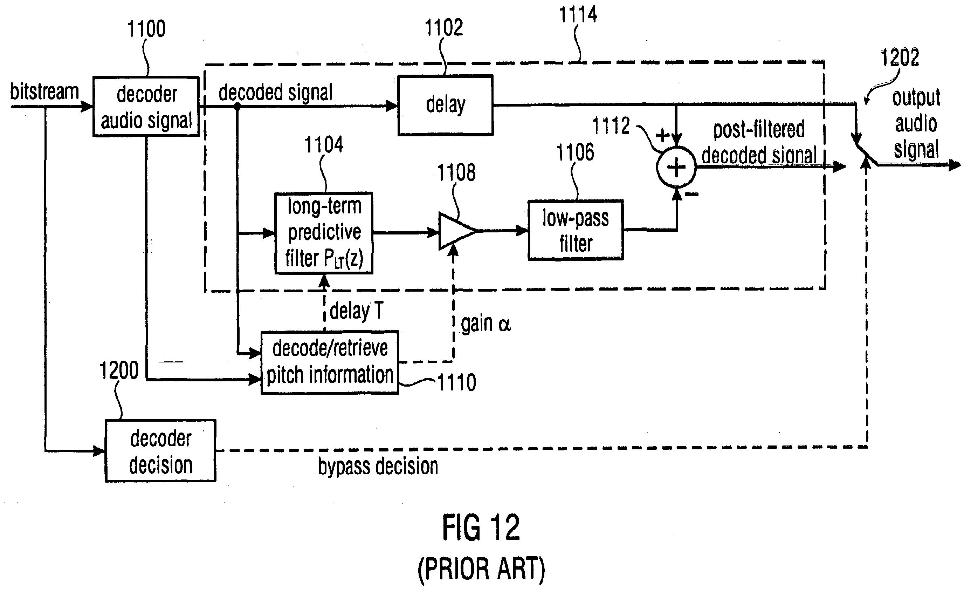

The bass post-filter was designed for enhancing the quality of clean speech but can create unexpected artifacts which can spoil the listening experience, especially when the anti-harmonic components are useful components in the original signal, as it can be the case for music or noisy speech. One solution of this problem can be found in [3], where the post-filter can be by-passed thanks to a decision determined either at the decoder side or at the encoder side. In the latest case, the decision needs to be transmitted within the bitstream as it is depicted in Figure 12.

In particular, Figs. 11 and 12 illustrate a decoder 1100 for decoding an audio signal encoded within a bitstream to obtain a decoded signal. The decoded signal is subjected to a delay in a delay stage 1102 and forwarded to a subtractor 1112. Furthermore, the decoded audio signal is input into a long-term prediction filter indicated by $P_{LT}(z)$. The output of the filter 1104 is input into a gam stage 1108 and the output of the gain stage 1108 is input into a low-pass filter 1106. The long-term prediction filter 1104 is controlled by a delay T and the gain stage 1108 is controlled by a gain a. The delay T is the pitch delay and the gain $\alpha$ is the pitch gain. Both values are decoded/retrieved by block 1110. Typically, the pitch gain and the pitch delay are additionally used by the decoder 1100 to generate a decoded signal such as a decoded speech signal

Fig. 12 additionally has the decoder decision block 1200 and a switch 1202 in order to either use the bass post-filter or not. The bass post-filter is generally indicated by 1114 in Fig. 11 and Fig. 12.

It has been found that controlling the bass post-filter by the pitch information such as the pitch gain and the pitch delay or the complete deactivation of the bass post-filter are not optimum solutions. Instead, the bass post-filter can enhance the audio quality substantively if the bass post-filter is correctly set On the other hand, the bass post-filter can seriously degrade the audio quality, when the bass post-filter is not controlled to have an optimum bass post-filter characteristic. Therefore, it is an object of the present invention to provide a coding concept having an improved audio quality.

This object is achieved by an apparatus for processing an encoded audio signal of claim 1, an encoder for generating an encoded signal of claim 9 ,a method of processing an encoded audio signal of claim 15, a method of generating an encoded signal of claim 16, a computer program of claim 17. An optimum control of the bass post-filter provides a significant audio quality improvement compared to a purely pitch information-driven control of the bass post-filter or compared to only activating/deactivating a bass post-filter. To this end, a bass post-filter control parameter is generated on the encoder-side typically using the encoded and again decoded signal and the original signal in the encoder, and this bass post-filter control parameter is transmitted to the decoder-side. In a decoder-side apparatus for processing an encoded signal, an audio signal decoder is configured for decoding the encoded audio signal using the pitch delay or the pitch gain to obtain a decoded audio signal Furthermore, a controllable bass post-filter for filtering the decoded audio signal is provided to obtain a processed signal, where this controllable bass post-filter has a controllable bass post-filter characteristic controllable by the bass post-filter control parameter. Furthermore, a controller is provided for setting the variable bass post-filter characteristic in accordance with the bass post-filter control parameter included in the encoded signal in addition to the pitch delay or the pitch gain included in the encoded audio signal.

Thus, the bass post-filter is a filter applied at the output of some speech decoders and aims to attenuate the anti-harmonic noise introduced by a lossy coding of speech. In an embodiment, the optimal attenuation factor of the anti-harmonic components is calculated by means of a minimum mean square error (MMSE) estimator. Preferably, the quadratic error between the original signal and the post-filtered decoded signal is the cost function to be minimized. The thus obtained optimal factor is computed at the encoder side before being quantized and transmitted to the decoder. In addition or alternatively, it is also possible to optimize at the encoder side the other parameters of the bass post-filtering, i.e. the pitch delay T and a filter characteristic. Preferably, the filter characteristic is a low-pass filter characteristic, but the present invention is not restricted to only filters having a low-pass characteristic. Instead, other filter characteristics can be an all-pass filter characteristic, a band-pass filter characteristic or a high-pass filter characteristic. The index of the best filter is then transmitted to the decoder.

In further embodiments, a multi-dimensional optimization is performed by optimizing, at the same time, a combination of two or three parameters out of the gain/attenuation parameter, the delay parameter or the filter characteristic parameter.

Preferred embodiments are subsequently discussed in the context of the accompanying drawings and are additionally discussed in the enclosed dependent claims.

Fig. 1      illustrates an embodiment of an apparatus for processing encoded audio signal,
Fig. 2      illustrates a further embodiment of an apparatus for processing an encoded signal;
Fig. 3      illustrates a further apparatus for processing an encoded audio signal operating in a spectral domain;
Fig. 4      illustrates a schematic representation of a controllable bass post-filter of Fig. 1;
Fig. 5      illustrates operations performed by the controller of Fig. 1;
Fig. 6      illustrates an encoder for generating an encoded signal in an embodiment;
Fig. 7a      illustrates a further embodiment of an encoder,
Fig. 7b      illustrates equations/steps performed by an apparatus/method for generating an encoded signal;
Fig. 8      illustrates procedures performed by the processor of Fig. 6;
Fig. 9      illustrates steps or procedures performed by the processor of Fig. 6 in a further embodiment;
Fig. 10      illustrates a further implementation of the encoder/processor of Fig. 6;
Fig. 11      illustrates a prior art signal processing apparatus; and
Fig. 12      illustrates a further prior art signal processing apparatus.

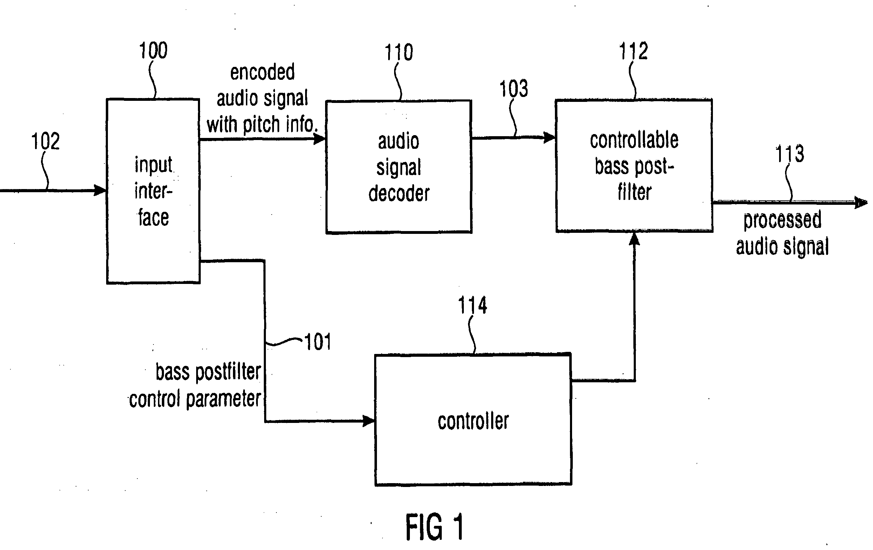

Fig. 1 illustrates the apparatus for processing encoded signal. The encoded signal is input into an input interface 100. At the output of the input interface 100, an audio signal decoder for decoding the encoded audio signal is provided. The encoded signal input into the input interface 100 comprises an encoded audio signal having an information on a pitch delay or a pitch gain. Furthermore, the encoded signal comprises a bass post-filter control parameter. This bass post-filter control parameter is forwarded from the input interface 100 to the controller 114 for setting a variable bass post-filter characteristic of a controllable bass post-filter 112 in accordance with the bass post-filter control parameter included in the encoded signal This control parameter 101 is therefore provided in the encoded audio signal in addition to the information on the pitch delay or the pitch gain and may therefore be used to set the controllable bass post-filter characteristic in addition to the bass post-filter control parameters specifically included in the encoded signal 102.

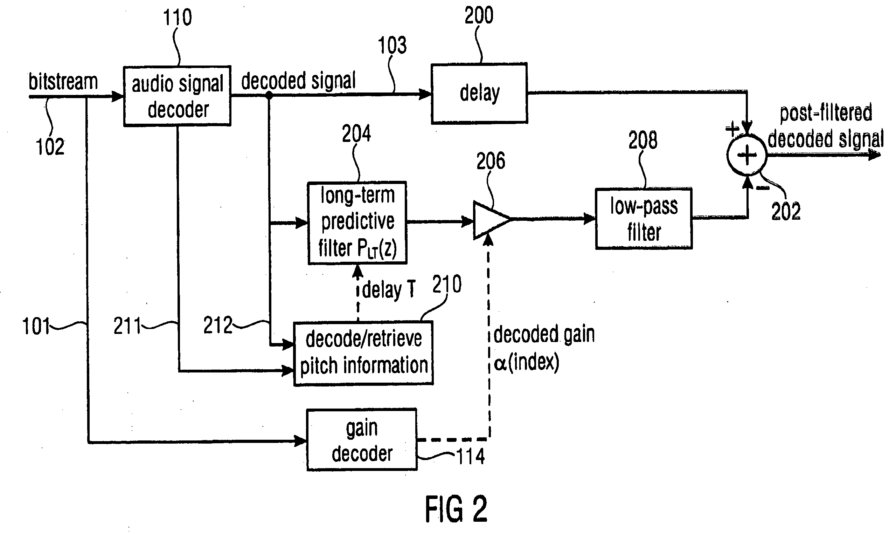

As illustrated in Fig. 2, the controllable bass post-filter 112 may comprise a long-term prediction filter $P_{LT}(z)$ indicated at 204, a subsequently connected gain stage 206 and a subsequently connected low-pass filter 208. In this context, however, it is emphasized that elements 204, 206, 208 can be arranged in any different order, i.e. the gain stage 206 can be arranged before the long-term prediction filter 204 or subsequent to the low-pass filter 208 and, equally, the order between the low-pass filter 208 the long-term prediction filter 204 can be exchanged so that the low-pass filter 208 is the first in the chain of processing. Furthermore, the characteristics of the prediction filter 204, the gain stage 206 and the low-pass filter 208 can be merged into a single filter (or into two cascaded filters) having a product of the transfer functions of the three elements.

In Fig. 2, the bass post-filter control parameter 101 is a gain value for controlling the gain stage 206 and this gain value 101 is decoded by the gain decoder 114 which is included in the controller 114 of Fig. 1. Thus, the gain decoder 114 provides a decoded gain $\alpha$(index) and this value is applied to the variable gain stage 206. The result of the procedures in Fig. 1 and Fig. 2 and the other procedures of the present invention is a processed or post-filtered decoded signal having a superior quality compared to the procedures illustrated in Fig. 11 and Fig. 12. In particular, the controller 114 in Fig. 1 additionally comprises a block 210 for decoding/retrieving pitch information, i.e. information on a pitch delay T and/or information on a pitch gain $g_{ltp}$. This derivation of this data can either be performed by simply reading the corresponding information from the encoded signal illustrated by line 211 or by actually analyzing the decoded audio signal illustrated by line 212. However, when the audio signal decoder is a speech decoder, then the encoded audio signal will comprise explicit information on a pitch gain or a pitch delay. However, when this information is not present, it can be derived from the decoded signal 103 by block 210. This analysis may, for example, be a pitch analysis or pitch tracking analysis or any other well-known way of deriving a pitch of an audio signal. Additionally, the block 210 cannot only derive the pitch delay or pitch frequency but can also derive the pitch gain.

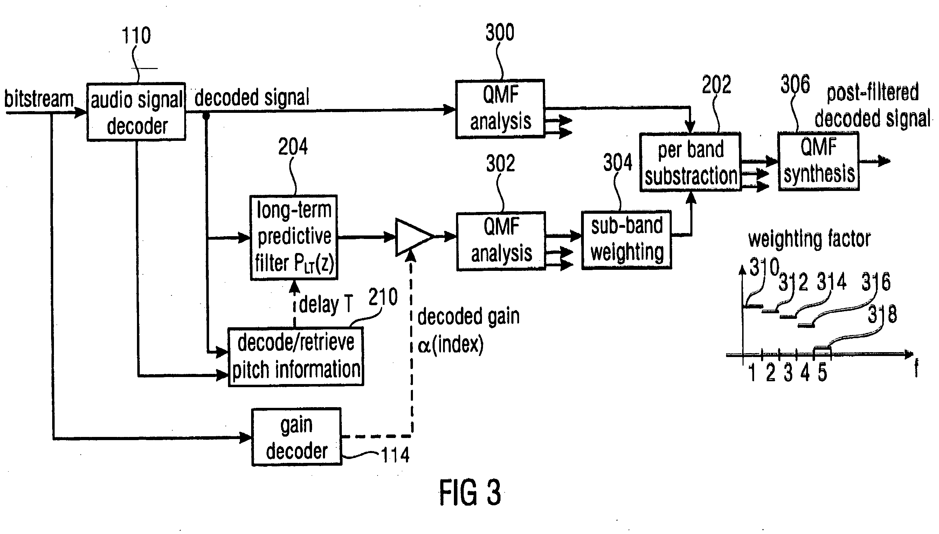

Fig. 2 illustrates a preferred implementation of the present invention operating in the time-domain. Contrary thereto, Fig. 3 illustrates an implementation of the present invention operating in a spectral domain. Exemplarily, a QMF subband domain is illustrated in Fig. 3. In contrast to Fig. 2, a QMF analyzer 300 is provided for converting the decoded signal into a spectral domain, preferably the QMF domain. Furthermore, a second time to spectrum converter 302 is provided which is preferably implemented as the QMF analysis block. The low-pass filter 208 of Fig. 2 is replaced by a subband weighting block 304 and the subtractor 202 of Fig. 2 is replaced by a per band subtracter 202. Additionally, a QMF synthesis block 306 is provided. In particular, the QMF analysis 302 provides a plurality of individual subbands or spectral values for individual frequency bands. These individual bands are then subjected to the sub-band weighting 304, where the weighting factor is different for each individual band so that all weighting factors together represent, for example, a low-pass filter characteristic. Thus, when for example five bands are considered, and when a low-pass filter characteristic is to be implemented by the subband weighting blocks 304 for the individual bands, then the weighting factors applied by the subband weighting blocks 304 will decrease from a high value for the lowest band to a lower value for a higher band. This is illustrated by the sketch to the right of Fig. 3 exemplarily illustrating five bands with band numbers 1, 2, 3, 4, 5, where each band has an individual weighting factor. Band 1 has the weighting factor 310 applied by block 304, band 2 has the weighting factor 312, band 3 has the weighting 314, band 4 has the weighting factor 316 and band 5 has the weighting factor 318. It can be seen that a weighting factor for a higher band such as band 5 is lower than a weighting factor for the lower band such as band 1. Thus, a low-pass filter characteristic is implemented. On the other hand, the weighting factors can be arranged in a different order in order to apply a different filter characteristic depending on the certain use case.

Thus, compared to Fig. 2, a time-domain low-pass filtering in block 208 is replaced by the two time-to-spectrum converters 300, 302 and the spectrum-to-time converter 306.

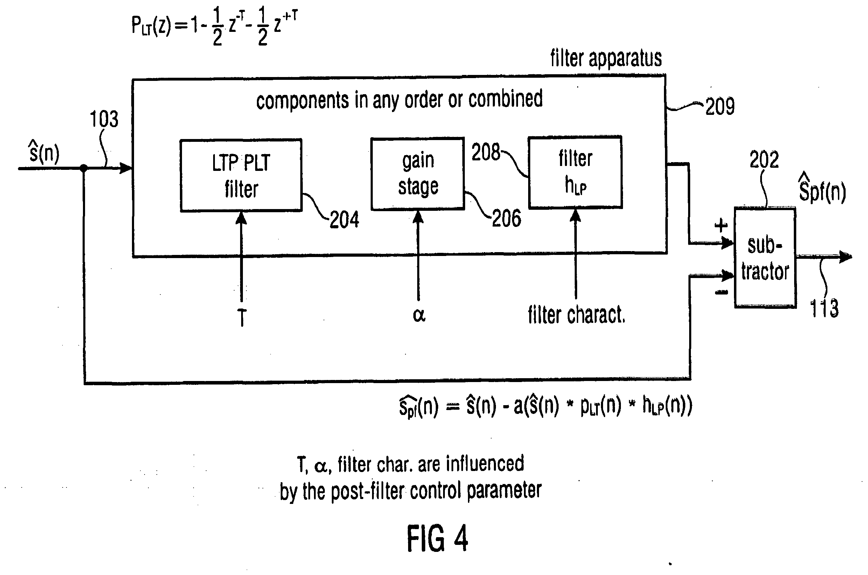

Fig. 4 illustrates a preferred implementation of the controllable bass post-filter 112 of Fig. 1. Preferably, the bass post-filter 112 comprises a filter apparatus 209 and a subtractor 202. The filter apparatus receives, at its input, the decoded signal 103. Preferably, the filter apparatus 208 comprises a functionality of a long-term prediction filter 204, the functionality of a gain stage 206 and the functionality of a signal manipulator, where this signal manipulator can, for example, be an actual filter 208 as would be the case in the implementation of Fig. 2. Alternatively the signal manipulator can be a weighter for an individual subband or spectrum band as in the implementation of Fig. 3, element 304.

Elements 204, 200, 208 can be arranged in any order or any combination and can even be implemented within a single element as discussed in the context of Fig. 2. The output of the subtracter 202 is the processed or post-filtered signal 113.

Depending on the implementation, the controllable parameters of the filter apparatus are the delay T for the long-term prediction filter 204, the gain value $\alpha$ for the gain stage 206 and the filter characteristic for the signal manipulator/filter 208. All these parameters can be individually or collectively influenced by the bass post-filter control parameter additionally included in the bitstream as discussed in the context of element 101 of Fig. 1.

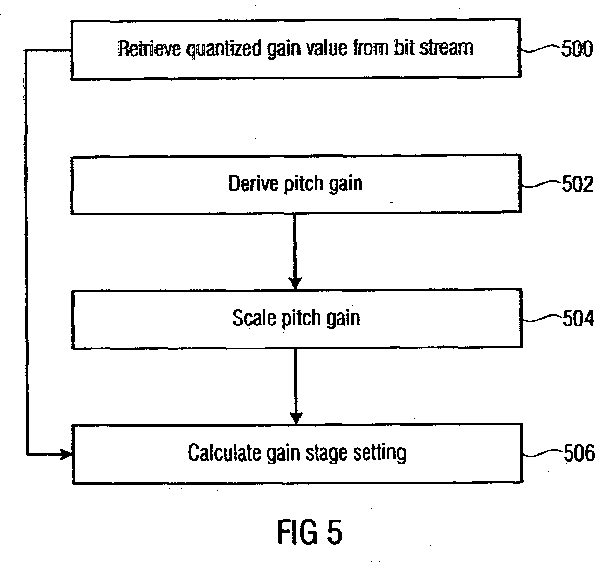

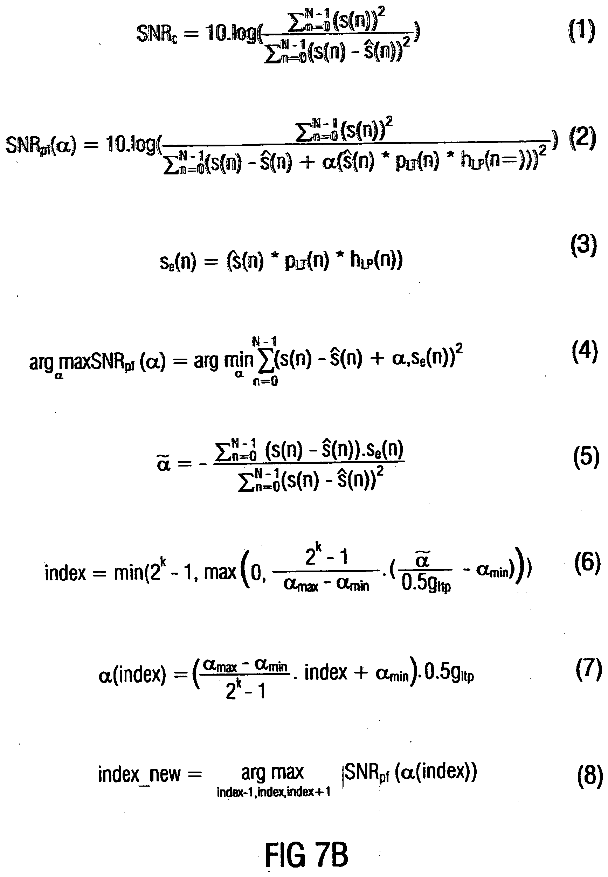

Fig. 5 illustrates a procedure for deriving the actually decoded gain $\alpha$(index) illustrated in Fig. 3. To this end, a quantized gain value is retrieved from the bitstream by parsing the encoded signal to obtain the bass post-filter control parameter representing the retrieved value of step 500. Furthermore, in step 502 a pitch gain is derived using the information on the pitch gain included in the encoded audio signal or by analyzing the decoded audio signal as discussed in the context of block 210 in Fig. 2 and Fig.3. Then, subsequently the derived pitch gain 502 is scaled using a scaling factor being greater than zero and lower than 1.0 as illustrated in step 504. Then, the gain stage setting or gain value $\alpha$(index) is calculated using the quantized gain value obtained in step 500 and the scaled pitch gain obtained in step 504. In particular, reference is made to equation (7) in Fig. 7b. The gain stage setting a(index) calculated in step 506 of Fig. 5 relies on a scaled pitch gain obtained by a step 504. The pitch gain is $g_{ltp}$ and the scaling factor in this embodiment is 0.5. Other scaling factors between 0.3 and 0.7 are preferred as well. The pitch gain $g_{ltp}$ used in equation (7) in Fig. 7b is calculated/retrieved by block 210 of Fig. 3 or Fig. 2 as discussed before and corresponds to the information on the pitch gain included in the encoded audio signal.

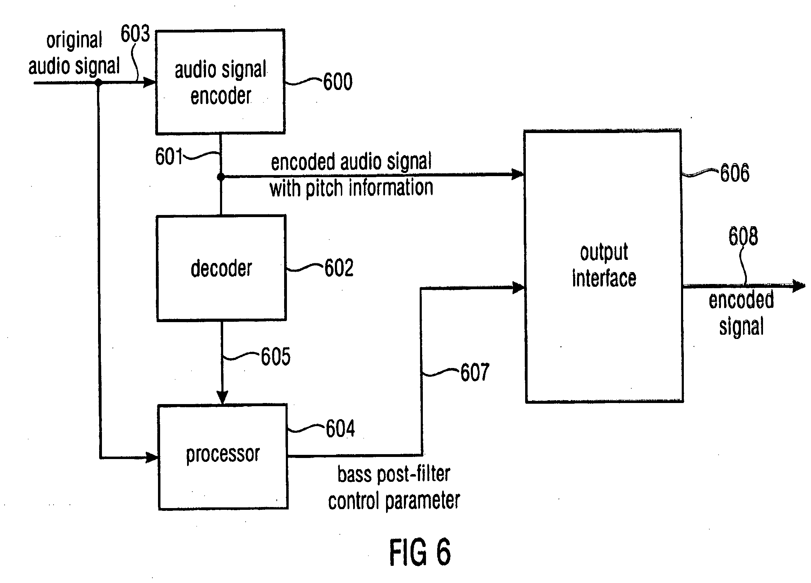

Fig. 6 illustrates an encoder for generating an encoded signal in accordance with an embodiment of the present invention. In particular, the encoder comprises an audio signal encoder 600 for generating an encoded audio signal 601 comprising information on a pitch gain or a pitch delay, and this encoded audio signal is generated from an original audio signal 603. Furthermore, a decoder 602 is provided for decoding the encoded audio signal to obtain a decoded audio signal 605. Furthermore, a processor 604 is provided for calculating a bass post-filter control parameter 607 fulfilling an optimization criterion, wherein the decoded signal 605 and the original audio signal 603 are used for calculating the bass post-filter control parameter 607. Furthermore, the encoder comprises an output interface 606 for outputting the encoded signal 608 having the encoded audio signal 601, the information on the pitch gain and the information on the pitch value and additionally having the bass post-filter control parameter 607.

It is to be emphasized that although not explicitly stated, similar reference numbers in the figures illustrate similar elements and changes will appear from the discussion of the individual elements in the context of the individual figures.

In an embodiment, the processor 604 is configured to calculate the bass post-filter control parameter so that a signal-to-noise ratio between an original signal input into the audio signal encoder 600 and a decoded and bass post-filtered audio signal is minimized.

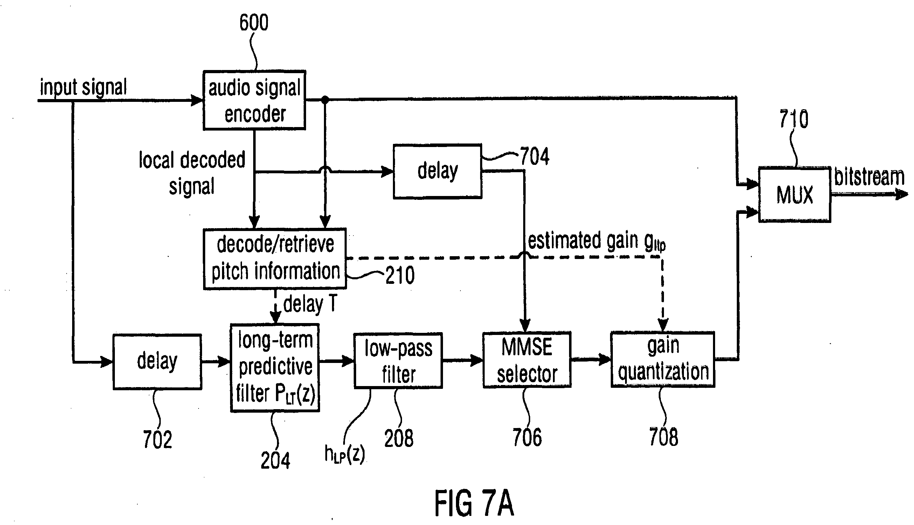

In a further embodiment as illustrated in Fig. 7a, the processor 604 comprises a long-term prediction filter 204 controlled by a pitch delay T, a low-pass filter 208 or a gain stage 206, and wherein the processor 604 is configured to generate, as the bass post-filter control parameter, a pitch delay parameter, a low-pass filter characteristic or a gain stage setting.

In a further embodiment, the processor 604 further comprises a quantizer for quantizing the bass post-filter control parameter. In the embodiment of Fig. 7a, this quantizer is a gain quantizer 708. In particular, the quantizer is configured to quantize to a predetermined number of quantization indices which have a significantly smaller resolution compared to a resolution provided by a computer or processor. Preferably, the predetermined number of quantization indices is equal to 32 allowing a 5-bit quantization, or even equal to 16 allowing a 4-bit quantization, or even equal to 8 allowing a 3-bit quantization, or even equal to 4 allowing a 2-bit quantization.

In a preferred embodiment, the processor 604 is configured to calculate the bass post-filter control parameters so that the optimization criterion is fulfilled for quantized bass post-filter control parameters. Thus, the additional inaccuracy introduced by the quantization is already included into the optimization process.

The post-filtering in the prior art is based on a storng assumption regarding the nature of the signal and the nature of the coding artifacts. It is based on estimators, the gain $\alpha$, the delay T and the low-pass filter, which may not be optimal. This invention proposes a method for optimizing at least one of the parameter at the encoder side before quantizing it and sending it to the decoder.

An aspect of the invention is about determining analytically (Fig. 7b, equations (1) - (5)) the optimal gain $\alpha$ to apply in the bass post-filter. The coding gain is preferably expressed as a Signal-to-Noise Ratio in dB:

$$SNR_c = 10.\log\left(\frac{\sum_{n=0}^{N-1}\left(s(n)\right)^2}{\sum_{n=0}^{N-1}\left(s(n)-\hat{s}(n)\right)^2}\right)$$

Where $s(n)$ is the original signal and $\hat{s}(n)$ the decoded version. This coding gain is modified after applying the post-filter and becomes:

$$SNR_{pf}(\alpha) = 10.\log\left(\frac{\sum_{n=0}^{N-1}(s(n))^2}{\sum_{n=0}^{N-1}(s(n)-\hat{s}(n)+\alpha(\hat{s}(n)*p_{LT}(n)*h_{LP}(n)))^2}\right)$$

Where $s_e(n) = (\hat{s}(n)*P_{LT}(n)*h_{LP}(n))$ is the anti-harmonic component filtered by the low-pass filter $H_{LP}(z)$.

Optimizing the gain $\alpha$ is terms of coding gain is equivalent to estimate the minimum mean square error. It can be expressed as:

$$\arg\max_{\alpha} SNR_{pf}(\alpha) = \arg\min_{\alpha} \sum_{n=0}^{N-1}(s(n)-\hat{s}(n)+\alpha.s_e(n))^2$$

The optimal gain $\tilde{\alpha}$ is then given by:

$$\tilde{\alpha} = -\frac{\sum_{n=0}^{N-1}\left(s(n)-\hat{s}(n)\right).s_e(n)}{\sum_{n=0}^{N-1}\left(s(n)-\hat{s}(n)\right)^2}$$

The maximum SNR is then $SNR_{pf}(\tilde{\alpha})$ .

The optimal gain has to be computed at the encoder side as it needs the original signal. The optimal gain must be then quantized. In the preferred embodiment et is done by coding it relatively to an estimation of the gain, which can be already decoded from the bitstream and used by the decoder. This estimation is preferably the long-term prediction

quantized gain $g_{ltp}$ multiplied by 0.5. If no Long-term prediction is available in the audio coder, one can code the absolute value of the optimal gain and compute the estimate of the delay T at both, encoder and decoder from the decoded signal. Though, in this case and in the preferred embodiment, the optimal gain is not sent and set at the decoder side to zero. The post-filter has then no effect on the decoded signal, and the delay T does not have to be estimated. In this case the bass post-filter control parameter 607 does not need to be either computed or transmitted.

In the preferred embodiment the quantization is done as described by the following pseudo-code (Fig. 7b, equation (6)):

$$index = \min(2^k - 1, \max\left(0, \frac{2^k - 1}{\alpha_{max} - \alpha_{min}} \cdot (\frac{\tilde{a}}{0.5g_{ltp}} - \alpha_{min})\right))$$

Where k is the number of bits on which is quantized the optimal gain, $\alpha_{min}$ and $\alpha_{max}$ are the minimum and the maximum relative quantized gains respectively. In the preferred embodiment k=2, i.e. the quantized gain is sent every frame on 2 bits. In the preferred embodiment $\alpha_{max}$ = 1.5 and $\alpha_{min}$ = 0.

The decoded optimal gain is then equal to (Fig. 7b, equation (7)):

$$\alpha(index) = \left(\frac{\alpha_{max} - \alpha_{min}}{2^k - 1} \cdot index + \alpha_{min}\right) \cdot 0.5g_{ltp}$$

It can happen that the above quantization in not optimal in terms of SNR. It can be avoided by computing for each representative values the resulting $SNR_{pf}(\alpha(index))$, but if the number of bits $k$ is high the computational complexity can explodes. Instead one can quantize the gain as it is described above and then check if the nearby representative values are a better choice (Fig. 7b, equation (8)):

$$index\_new = \underset{index-1, index, index+1}{\arg\max} SNR_{pf}(\alpha(index))$$

*index_new* will be then transmitted instead of *index*.

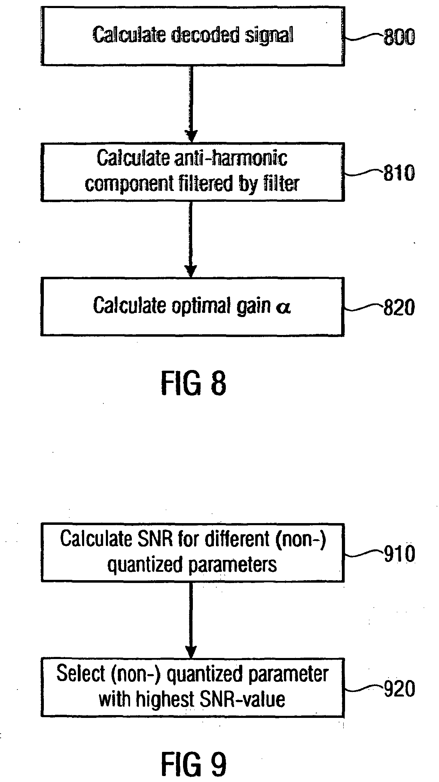

Fig. 8 illustrates a further embodiment of the encoder-side method. In step 800, the decoded signal is calculated. This is done by, for example, the decoder 602 in Fig. 6. In step 810, the anti-harmonic component filtered by the filter is calculated by the processor 604. The anti-harmonic component filtered by the filter 208, for example in Fig. 7a, is $s_e(n)$ as dafined in equation (3). Thus, the anti-harmonic component filtered by the, for example, low-pass filter $H_{LP}(z)$ is obtained by filtering the decoded signal at the output 605 of Fig. 6 using the long-term prediction filter 204, for example of Fig. 7a and the low-pass filter 208 having a transfer function in the z-domain $h_{LP}(z)$.

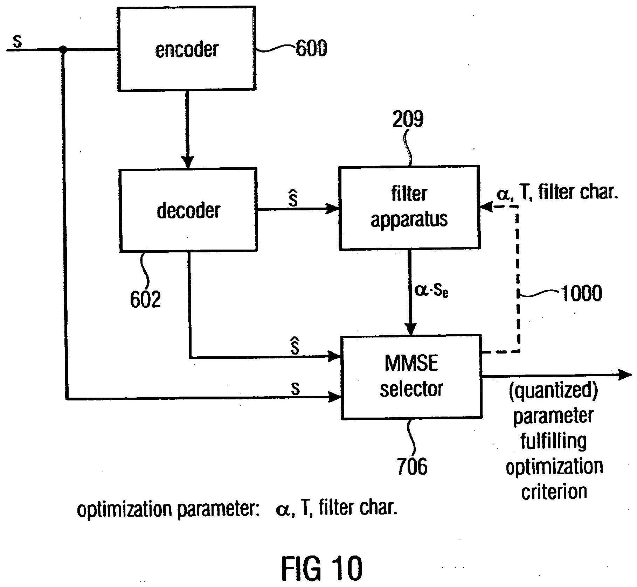

Then, the optimal gain $\alpha$ is calculated by the processor 604 as illustrated in step 820 of Fig. 8. This may, for example, be done using equation (4) or equation (5) in order to obtain a non-quantized optimum gain. The best quantized gain can, for example, be obtained by equation (6) or equation (8) of Fig. 7b. However, the calculation of the optimal gain $\alpha$ as defined in step 820 does not necessarily have to be performed in an analytical way, but can also be done by any other procedure using the calculated anti-harmonic component filtered by the filter on the one hand and using the original signal s on the other hand. To this end, reference is made to Fig. 9 and Fig. 10. Fig. 10 illustrates a further embodiment of the inventive encoder. The encoder 600 in Fig. 10 corresponds to the audio signal encoder 600 of Fig. 6. Similarly, the decoder 602 of Fig. 10 corresponds to the decoder 602 of Fig. 6. Furthermore, the processor 604 of Fig. 6 comprises, on the one hand, the filter apparatus 209 and on the other hand, the MMSE selector 706.

The decoder 602 calculates the decoded signal $\hat{s}$. The decoded signal $\hat{s}$ is input into the filter apparatus 209 in order to obtain the anti-harmonic component as discussed in step 810 of Fig. 8 multiplied by a certain gain factor $\alpha$. Then, MMSE selector 706 calculates, for example, a signal-to-noise ratio for different (non-) quantized parameters as indicated at step 910 in Fig. 9. The calculation of the SNR is performed by evaluating the equation (2) or (4) or any other procedure involving $(s(n) - \hat{s}(n) + \alpha \cdot s_e(n))$. Then, as indicated by step 920, the MMSE selector 706 selects the non-quantized or, alternatively, the quantized parameter with the highest SNR value in order to obtain, at the output of block 706, the quantized or non-quantized parameter fulfilling the optimization criterion.

Thus, the MMSE selector 706 may perform an exhaustive search, for example, for each $\alpha$ value. Alternatively, the MMSE selector can set a certain $\alpha$ value and then calculate different anti-harmonic components $\alpha \cdot s_e$ for individual

pitch delay values T. Furthermore, a certain $\alpha$ value and a certain T value can be predefined and individual anti-harmonic components can be calculated for individual filter characteristics. This is illustrated by the control line 1000 in Fig. 10. In further embodiments, a multi-dimensional optimization is performed in that all available combinations of $\alpha$, T values and individual filter characteristics are set and the corresponding SNR value is calculated for each combination of the three parameters and the processor 604 corresponding to the combination of the filter apparatus 209 and the MMSE selector 706 when selecting the quantized or non-quantized parameter with the highest SNR value in a preferred embodiment or one of the for example ten parameter combinations having the highest SNR values among all possibilities.

Subsequently, additional reference is made to Fig. 1 to Fig. 5 illustrating the decoder-side of the present invention.

At the decoder side the adaptive bass post-filter is illustrated in Fig. 1 or 2. First the gain is decoded, and then the used for post-filtering of the decoded audio signal. It is worth notifying that in case the gain is quantized to zero, it will be is equivalent to by-pass the post-filtering. In this last case only the memory of the filters are updated.

Finally, it is not restricted that the low-pass filter is performed in the time domain. It can be applied in the frequency by mean of a multiplication of the frequency bins and sub-bands. One can use a FFT, a MDCT, a QMF or any spectral decomposition. In the preferred embodiment the low-pass filter is applied in time-domain at the encoder side and in QMF domain at the decoder.

According to other embodiments, it is also possible to optimize at the encoder side the other parameters of the bass post-filtering, i.e. the delay $T$ and the filter $h_{LP}(n)$. The analytic resolution of their optimization is more complex, but an optimization can be achieved by computing the coding gain $SNR_{pf}(T)$ or $SNR_{pf}(h_{LP}(n))$ at the output of the post-filter with different parameter candidates. The candidate having the best SNR is then selected and transmitted. For the delay, good candidates can be chosen in the surrounding of the first estimation, and then only the delta with the estimated delay needs to be transmitted. For the low-pass filter, a set of filter candidates can be predefined and the SNR is computed for each of them. Naturally it is not restricted that all filters show a low-pass characteristic. One or more candidates can be an all-pass, a band-pass, or a high-pass filter. The index of the best filter is then transmitted to the decoder. In another embodiment one can do a multi-dimensional optimization be optimizing in the same time the combination of two or three parameters.

Although the present invention has been described in the context of block diagrams where the blocks represent actual or logical hardware components, the present invention can also be implemented by a computer-implemented method. In the latter case, the blocks represent corresponding method steps where these steps stand for the functionalities performed by corresponding logical or physical hardware blocks.

Although some aspects have been described in the context of an apparatus, it is dear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, some one or more of the most important method steps may be executed by such an apparatus.

The inventive transmitted or encoded signal can be stored on a digital storage medium or can be transmitted on a transmission medium such as a wireless transmission medium or a wired transmission medium such as the Internet.

Depending on certain implementation requirements, embodiments of the invention can be implemented in hardware or in software. The implementation can be performed using a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive method is, therefore, a data carrier (or a non-transitory storage medium such as a digital storage medium, or a computer-readable medium) comprising, recorded thereon, the computer program for performing one of the methods described herein. The data carrier, the digital storage medium or the recorded medium are typically tangible and/or non-transitory.

A further embodiment of the invention method is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an I apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

References

[1] 3GPP TS 16.290 Audio codec processing functions; Extended Adaptive Multi-Rate - Wideband (AMR-WB+) codec; Transcoding functions

[2] Recommendation ITU-T G.718 : "Frame error robust narrow-band and wideband embedded variable bit-rate coding of speech and audio from 8-32 kbit/s"

[3] International patent WO2012/000882 A1, "Selective Bass Post Filter".

**Claims**

1.  Apparatus for processing an encoded signal (110), the encoded signal comprising an encoded audio signal having information on a pitch delay, a pitch gain, and a bass post-filter control parameter (101), comprising:

    an audio signal decoder (110) for decoding the encoded audio signal using the information on the pitch delay or the pitch gain to obtain a decoded audio signal (103);
    a controllable bass post-filter (112) for filtering the decoded audio signal (103) to obtain a processed signal (113), wherein the controllable bass post-filter (112) has a variable bass post-filter characteristic controllable by the bass post-filter control parameter (101); and
    a controller (114) for setting the variable bass post-filter characteristic in accordance with the bass post-filter control parameter (101) included in the encoded signal (102),
    wherein the controllable bass post-filter (112) comprises a filter apparatus (209) comprising a long-term prediction filter (204), a gain stage (206), a signal manipulator (208), and a subtractor (202) for subtracting an output of the filter apparatus (209) from the decoded audio signal (103),
    wherein the bass post-filter control parameter (101) comprises a quantized gain value for the gain stage (206),
    wherein the controller (114) is configured to set the gain stage (206) in accordance with the quantized gain value,
    wherein the controller (114) comprises a block (210) for decoding or retrieving the information on a pitch delay and wherein the controller (114) is configured to set the long-term prediction filter (204) in accordance with the pitch delay,
    wherein the controller is configured
    to retrieve (500) the quantized gain value from the encoded signal to obtain the bass post-filter control parameter (101),
    to scale (504) the pitch gain by a constant factor lower than 1 and greater than 0 to obtain a scaled pitch gain; and
    to calculate (506) a setting of the gain stage using the scaled pitch gain and using the quantized gain value.

**2.** Apparatus of claim 1,
wherein the controllable bass post-filter (112) is configured to operate in a time domain,
wherein the signal manipulator (208) is implemented as a low-pass filter, an all-pass filter, a band-pass filter or a high-pass filter, and
wherein the bass post-filter control parameter comprises in addition to a gain value for the gain stage (206) a filter characteristic information for the signal manipulator (208) and,
wherein the controller (114) is configured to set the signal manipulator (208) in accordance with the information on the filter characteristic.

**3.** Apparatus of claim 1 or 2.,
wherein the controllable bass post-filter (112) is configured to operate in a spectral domain,
wherein a first time-to-spectrum converter (300) for generating a spectral representation of the decoded audio signal (103) is provided,
wherein the controllable bass post-filter (112) comprises a second time-to-spectrum converter (302) to generate subband signals for different subbands and a signal manipulator (304) for each subband, wherein the signal manipulator for a subband is configured for performing a weighting operation using a weighting factor (310, 312, 314, 316, 318), and wherein individual weighting factors (310-318) for signal manipulators (304) for individual subbands together implement a low-pass filter characteristic, an all-pass filter characteristic, a band-pass filter characteristic or a high-pass filter characteristic, wherein the subtractor is configured for subtracting an output of the filter apparatus for a subband from a corresponding subband generated by the first time-to-spectrum converter (300) to generate a subtracted subband signal; and
a spectrum-to-time converter (306) for converting subtracted subband signals into a time domain to obtain the processed signal (113);
wherein the bass post-filter control parameter comprises a gain value for the gain stage (206) and a filter characteristic information for the signal manipulator (208).

**4.** Apparatus of one of the preceding claims,
wherein the bass post-filter control parameter is quantized relative to the information on the pitch delay or the pitch gain included in the encoded audio signal, and
wherein the controller (114) is configured to set the variable bass post-filter characteristic in accordance with the information on the pitch delay or the information on the pitch gain and the bass post-filter control parameter.

**5.** Apparatus of claim 4,
wherein the controller (114) is configured to set the variable bass post-filter characteristic based on a product of the information on the pitch delay or the pitch gain and the bass post-filter characteristic (506).

**6.** Apparatus of claim 5,
wherein the controller is configured for calculating (506) a gain for the variable gain stage (206) using a product (504) between the bass post-filter control parameter and the pitch gain (502) and a constant factor lower than 1 and greater than 0.

**7.** Apparatus of one of the preceding claims,
wherein the controllable bass post-filter (112) comprises a long-term prediction filter (204) and a variable gain stage (206), wherein the long-term prediction filter (204) is controlled by the information on the pitch gain included in the encoded audio signal, and
wherein the controller (114) is configured to set a gain of the variable gain stage using the bass post-filter control parameter (101) alone or in combination with the information on the pitch gain.

**8.** Apparatus of claim 7,
wherein a low-pass filter (208) or a combination of a time-to-spectrum converter (302) and a subband weighter (304) is connected to an output of the variable gain stage (206) or an output of the long-term prediction filter (204).

**9.** Encoder for generating an encoded signal (608), comprising:

an audio signal encoder (600) for generating an encoded audio signal (601) having information on a pitch gain or a pitch delay from an original audio signal (603);
a decoder (602) for decoding the encoded audio signal to obtain a decoded audio signal;
a processor (604) for calculating a bass post-filter control parameter (607) fulfilling an optimization criterion using the decoded audio signal (605) and the original audio signal (603); and
an output interface (606) for outputting the encoded signal (608) having the encoded audio signal (601) comprising the information on the pitch gain or the pitch delay and the bass post-filter control parameter (607), wherein the processor (604) further comprises a quantizer (708) for quantizing the bass post-filter control parameter to one of a predetermined number of quantization indices, and
wherein the processor (604) is configured to calculate the bass post-filter control parameter so that the optimization criterion is fulfilled for a quantized bass post-filter control parameter.

10. Encoder of claim 9,
wherein the processor (604) is configured to calculate the bass post-filter control parameter (607) so that a signal-to-noise ratio between the original audio signal (603) and a decoded and bass post-filtered audio signal is minimized.

11. Encoder of claim 9 or 10,
wherein the processor (604) comprises a long-term prediction filter (204), a low-pass filter (208) or a gain stage (206), and
wherein the processor (604) is configured to generate, as the bass post-filter control parameter (607), a pitch delay parameter, a low-pass filter characteristic information or a gain stage setting.

12. Encoder of any one of claims 9 to 11,
wherein the quantizer (708) is configured for quantizing the bass post-filter control parameter with respect to the information on the pitch gain or the information on the pitch delay.

13. Encoder of claim 12,
wherein the quantizer (708) is configured to quantize the bass post-filter control parameter using the following equation:

$$index = \min\left(2^k - 1, \max\left(0, \frac{2^k-1}{\alpha_{max}-\alpha_{min}} \cdot \left(\frac{\tilde{\alpha}}{cg_{ltp}} - \alpha_{min}\right)\right)\right),$$

wherein *index* is the quantized bass post-filter control parameter (607), wherein min is a minimum function, wherein max is a maximum function, wherein *k* is the number of bits used to represent the index, wherein $\alpha_{min}$ is the minimum relative quantized gain, wherein $\alpha_{max}$ is the maximum relative quantized gain, wherein $\tilde{\alpha}$ is the non-quantized bass post-filter control parameter, wherein $g_{ltp}$ is the information on the pitch gain, and wherein c is a constant factor greater than 0 and lower than 1.

14. Encoder in accordance with one of the claims 9 to 13, wherein the processor (604) is configured for calculating (910) SNR values for a plurality of quantized or non-quantized bass post-filter control parameters and to select (920) the quantized or non-quantized bass post-filter control parameter resulting in an SNR value being among the five highest SNR values calculated, and
wherein the output interface (606) is configured for introducing the selected quantized or non-quantized bass post-filter control parameter into the encoded signal (608).

15. Method of processing an encoded signal (110), the encoded signal comprising an encoded audio signal having information on a pitch delay, a pitch gain, and a bass post-filter control parameter (101), comprising:

decoding (110) the encoded audio signal using the information on the pitch delay or the pitch gain to obtain a decoded audio signal (103);
filtering (112) the decoded audio signal (103) to obtain a processed signal (113) using a controllable bass post-filter (112) having a variable bass post-filter characteristic controllable by the bass post-filter control parameter (101); and
setting (114) the variable bass post-filter characteristic in accordance with the bass post-filter control parameter (101) included in the encoded signal (102),
wherein the controllable bass post-filter (112) comprises a filter apparatus (209) comprising a long-term prediction filter (204), a gain stage (206), a signal manipulator (208), and a subtractor (202) for subtracting an output of the filter apparatus (209) from the decoded audio signal (103),
wherein line bass post-filter control parameter (101) comprises a quantized gain value for the gain stage (206) or a filter characteristic information for the signal manipulator (208), and

wherein the setting (114) comprises setting the gain stage (206) in accordance with the quantized gain value, or setting the signal manipulator (208) in accordance with the information on the filter characteristic, wherein the setting comprises decoding or retrieving the information on a pitch delay and wherein the long-term prediction filter (204) is set in accordance with the pitch delay, wherein the setting comprises

retrieving (500) the quantized gain value from the encoded signal to obtain the bass post-filter control parameter (101),
scaling (504) the pitch gain by a constant factor lower than 1 and greater than 0 to obtain a scaled pitch gain; and
calculating (506) a setting of the gain stage using the scaled pitch gain and using the quantized gain value.

16. Method for generating an encoded signal (608), comprising:

generating (600) an encoded audio signal (601) having information on a pitch gain or a pitch delay from an original audio signal (603);
decoding (602) the encoded audio signal to obtain a decoded audio signal;
calculating (604) a bass post-filter control parameter (607) fulfilling an optimization criterion using the decoded audio signal (605) and the original audio signal (603);
and
outputting (606) the encoded signal (608) having the encoded audio signal (601) comprising the information on the pitch gain or the pitch delay and the bass post-filter control parameter (607),
wherein the calculating (604) further comprises quantizing the bass post-filter control parameter to one of a predetermined number of quantization indices, and
wherein the bass post-filter control parameter is calculated so that the optimization criterion is fulfilled for a quantized bass post-filter control parameter.

17. Computer program for performing, when running on a computer or processor, the method of claim 15 or the method of claim 16.

**Patentansprüche**

1. Vorrichtung zum Verarbeiten eines codierten Signals (110), wobei das codierte Signal ein codiertes Audiosignal mit Informationen über eine Tonhöhenverzögerung, einen Tonhöhengewinn und einen Bass-Nach-Filter-Steuerparameter (101) aufweist, die folgende Merkmale aufweist:

einen Audiosignaldecodierer (110) zum Decodieren des codierten Audiosignals unter Verwendung der Informationen über die Tonhöhenverzögerung oder den Tonhöhengewinn, um ein decodiertes Audiosignal (103) zu erhalten;
ein steuerbares Bass-Nach-Filter (112) zum Filtern des decodierten Audiosignals (103), um ein verarbeitetes Signal (113) zu erhalten, wobei das steuerbare Bass-Nach-Filter (112) eine variable Bass-Nach-Filter-Charakteristik aufweist, die durch den Bass-Nach-Filter-Steuerparameter (101) steuerbar ist; und
eine Steuerung (114) zum Einstellen der variablen Bass-Nach-Filter-Charakteristik gemäß dem Bass-Nach-Filter-Steuerparameter (101), der in dem codierten Signal (102) beinhaltet ist,
wobei das steuerbare Bass-Nach-Filter (112) eine Filtervorrichtung (209), die ein Langzeit-Vorhersagefilter (204), eine Gewinnstufe (206), einen Signalmanipulierer (208) aufweist, und einen Subtrahierer (202) zum Subtrahieren einer Ausgabe der Filtervorrichtung (209) von dem decodierten Audiosignal (103) aufweist,
wobei der Bass-Nach-Fitter-Steuerparameter (101) einen quantisierten Gewinnwert für die Gewinnstufe (206) aufweist,
wobei die Steuerung (114) ausgebildet ist, um die Gewinnstufe (206) gemäß dem quantisierten Gewinnwert einzustellen,
wobei die Steuerung (114) einen Block (210) zum Decodieren oder Wiedergewinnen der Informationen über eine Tonhöhenverzögerung aufweist, und wobei die Steuerung (114) ausgebildet ist, um das Langzeit-Vorhersagefilter (204) gemäß der Tonhöhenverzögerung einzustellen, wobei die Steuerung ausgebildet ist, um:

den quantisierten Gewinnwert aus dem codierten Signal wiederzugewinnen (500), um den Bass-Nach-Filter-Steuerparameter (101) zu erhalten,

den Tonhöhengewinn um einen konstanten Faktor, der kleiner als 1 und größer als 0 ist, zu skalieren (504), um einen skalierten Tonhöhengewinn zu erhalten; und

eine Einstellung der Gewinnstufe unter Verwendung des skalierten Tonhöhengewinns und unter Verwendung des quantisierten Gewinnwerts zu berechnen (506).

2. Vorrichtung gemäß Anspruch 1,
bei der das steuerbare Bass-Nach-Filter (112) ausgebildet ist, um in einem Zeitbereich zu arbeiten,
wobei der Signalmanipulierer (208) als ein Tiefpassfilter, ein Allpassfilter, ein Bandpassfilter oder ein Hochpassfilter implementiert ist, und
wobei der Bass-Nach-Filter-Steuerparameter zusätzlich zu einem Gewinnwert für die Gewinnstufe (206) eine Filtercharakteristikinformation für den Signalmanipulierer (208) aufweist, und
wobei die Steuerung (114) ausgebildet ist, um den Signalmanipulierer (208) gemäß den Informationen über die Filtercharakteristik einzustellen.

3. Vorrichtung gemäß Anspruch 1 oder 2,
bei der das steuerbare Bass-Nach-Filter (112) ausgebildet ist, um in einem Spektralbereich zu arbeiten,
wobei ein erster Zeit-zu-Spektrum-Wandler (300) zum Erzeugen einer Spektraldarstellung des decodierten Audiosignals (103) vorgesehen ist,
wobei das steuerbare Bass-Nach-Filter (112) einen zweiten Zeit-zu-Spektrum-Wandler (302) zur Erzeugung von Teilbandsignalen für unterschiedliche Teilbänder und einen Signalmanipulierer (304) für jedes Teilband aufweist,
wobei der Signalmanipulierer für ein Teilband zum Durchführen einer Gewichtungsoperation unter Verwendung eines Gewichtungsfaktors (310, 312, 314, 316, 318) ausgebildet ist, und wobei einzelne Gewichtungsfaktoren (310-318) für Signalmanipulierer (304) für einzelne Teilbänder zusammen eine Tiefpassfiltercharakteristik, eine Allpassfiltercharakteristik, eine Bandpassfiltercharakteristik oder eine Hochpassfiltercharakteristik implementieren,
wobei der Subtrahierer zum Subtrahieren einer Ausgabe der Filtervorrichtung für ein Teilband von einem entsprechenden Teilband, das durch den ersten Zeit-zu-Spektrum-Wandler (300) erzeugt wird, ausgebildet ist, um ein subtrahiertes Teilbandsignal zu erzeugen; und
einen Spektrum-zu-Zeit-Wandler (306) zum Wandeln subtrahierter Teilbandsignale in einen Zeitbereich, um das verarbeitete Signal (113) zu erhalten;
wobei der Bass-Nach-Filter-Steuerparameter einen Gewinnwert für die Gewinnstufe (206) und eine Filtercharakteristikinformation für den Signalmanipulierer (208) aufweist.

4. Vorrichtung gemäß einem der vorherigen Ansprüche,
bei der der Bass-Nach-Filter-Steuerparameter relativ zu den Informationen über die Tonhöhenverzögerung oder den Tonhöhengewinn, die in dem codierten Audiosignal beinhaltet sind, quantisiert ist, und
wobei die Steuerung (114) ausgebildet ist, um die variable Bass-Nach-Filter-Charakteristik gemäß den Informationen über die Tonhöhenverzögerung oder den Informationen über den Tonhöhengewinn und dem Bass-Nach-Filter-Steuerparameter einzustellen.

5. Vorrichtung gemäß Anspruch 4,
bei der die Steuerung (114) ausgebildet ist, um die variable Bass-Nach-Fitter-Charakteristik basierend auf einem Produkt der Informationen über die Tonhöhenverzögerung oder den Tonhöhengewinn und der Bass-Nach-Filter-Charakteristik (506) einzustellen.

6. Vorrichtung gemäß Anspruch 5,
bei der die Steuerung zum Berechnen (506) eines Gewinns für die variable Gewinnstufe (206) unter Verwendung eines Produkts (504) zwischen dem Bass-Nach-Filter-Steuerparameter und dem Tonhöhengewinn (502) und eines konstanten Faktors, der kleiner ist als 1 und größer als 0, ausgebildet ist.

7. Vorrichtung gemäß einem der vorherigen Ansprüche,
bei der das steuerbare Bass-Nach-Filter (112) ein Langzeit-Vorhersagefilter (204) und eine variable Gewinnstufe (206) aufweist, wobei das Langzeit-Vorhersagefilter (204) durch die Informationen über den Tonhöhengewinn, die in dem codierten Audiosignal beinhaltet sind, gesteuert wird, und
wobei die Steuerung (114) ausgebildet ist, um einen Gewinn der variablen Gewinnstufe unter Verwendung des Bass-Nach-Filter-Steuerparameters (101) alleine oder in Kombination mit den Informationen über den Tonhöhengewinn einzustellen.

8. Vorrichtung gemäß Anspruch 7,

bei der ein Tiefpassfilter (208) oder eine Kombination eines Zeit-zu-Spektrum-Wandlers (302) und eines Teilbandgewichters (304) mit einem Ausgang der variablen Gewinnstufe (206) oder einem Ausgang des Langzeit-Vorhersagefilters (204) verbunden ist.

9.  Codierer zum Erzeugen eines codierten Signals (608), der folgende Merkmale aufweist:

    einen Audiosignalcodierer (600) zum Erzeugen eines codierten Audiosignals (601) mit Informationen über einen Tonhöhengewinn oder eine Tonhöhenverzögerung aus einem ursprünglichen Audiosignal (603);
    einen Decodierer (602) zum Decodieren des codierten Audiosignals, um ein decodiertes Audiosignal zu erhalten;
    einen Prozessor (604) zum Berechnen eines Bass-Nach-Filter-Steuerparameters (607), der ein Optimierungskriterium erfüllt, unter Verwendung des decodierten Audiosignals (605) und des ursprünglichen Audiosignals (603); und
    eine Ausgangsschnittstelle (606) zum Ausgeben des codierten Signals (608) mit dem codierten Audiosignal (601), das die Informationen über den Tonhöhengewinn oder die Tonhöhenverzögerung und den Bass-Nach-Filter-Steuerparameter (607) aufweist,
    wobei der Prozessor (604) ferner einen Quantisierer (708) zum Quantisieren des Bass-Nach-Filter-Steuerparameters auf einen einer vorbestimmten Anzahl von Quantisierungsindizes aufweist, und
    wobei der Prozessor (604) ausgebildet ist, um den Bass-Nach-Filter-Steuerparameter so zu berechnen, dass das Optimierungskriterium für einen quantisierten Bass-Nach-Filter-Steuerparameter erfüllt ist.

10. Codierer gemäß Anspruch 9,
    bei dem der Prozessor (604) ausgebildet ist, um den Bass-Nach-Filter-Steuerparameter (607) so zu berechnen, dass ein Signal-Rausch-Verhältnis zwischen dem ursprünglichen Audiosignal (603) und einem decodierten und Bass-Nach-Filter-Audiosignal minimiert ist.

11. Codierer gemäß Anspruch 9 oder 10,
    bei dem der Prozessor (604) ein Langzeit-Vorhersagefilter (204), ein Tiefpassfilter (208) oder eine Gewinnstufe (206) aufweist, und
    wobei der Prozessor (604) ausgebildet ist, um als den Bass-Nach-Filter-Steuerparameter (607) einen Tonhöhenverzögerungsparameter, eine Tiefpassfiltercharakteristikinformation oder eine Gewinnstufeneinstellung zu erzeugen.

12. Codierer gemäß einem der Ansprüche 9 bis 11,
    bei dem der Quantisierer (708) zum Quantisieren des Bass-Nach-Filter-Steuerparameters in Bezug auf die Informationen über den Tonhöhengewinn oder die Informationen über die Tonhöhenverzögerung ausgebildet ist.

13. Codierer gemäß Anspruch 12,
    bei dem der Quantisierer (708) ausgebildet ist, um den Bass-Nach-Filter-Steuerparameter unter Verwendung folgender Gleichung zu quantisieren:

$$index = \min\left(2^k - 1, \max\left(0, \frac{2^k - 1}{\alpha_{max} - \alpha_{min}} \cdot \left(\frac{\tilde{\alpha}}{c g_{ltp}} - \alpha_{min}\right)\right)\right),$$

    wobei *index* der quantisierte Bass-Nach-Filter-Steuerparameter (607) ist, wobei min eine Minimumfunktion ist, wobei max eine Maximumfunktion ist, wobei k die Anzahl von Bits ist, die zur Darstellung des Index verwendet werden, wobei $\alpha_{min}$ der minimale relative quantisierte Gewinn ist, wobei $\alpha_{max}$ der maximale relative quantisierte Gewinn ist, wobei $\tilde{\alpha}$ der nicht quantisierte Bass-Nach-Filter-Steuerparameter ist, wobei $g_{ltp}$ die Informationen über den Tonhöhengewinn ist und wobei c ein konstanter Faktor ist, der größer ist als 0 und kleiner als 1.

14. Codierer gemäß einem der Ansprüche 9 bis 13, bei dem der Prozessor (604) zum Berechnen (910) von SNR-Werten für eine Mehrzahl quantisierter oder nicht quantisierter Bass-Nach-Filter-Steuerparameter ausgebildet ist, und um den quantisierten oder nicht quantisierten Bass-Nach-Filter-Steuerparameter auszuwählen (920), der zu einem SNR-Wert führt, der unter den fünf höchsten berechneten SNR-Werten ist, und
    wobei die Ausgangsschnittstelle (606) zum Einführen des ausgewählten quantisierten oder nicht quantisierten Bass-Nach-Filter-Steuerparameters in das codierte Signal (608) ausgebildet ist.

15. Verfahren zum Verarbeiten eines codierten Signals (110), wobei das codierte Signal ein codiertes Audiosignal mit Informationen über eine Tonhöhenverzögerung, einen Tonhöhengewinn und einen Bass-Nach-Fiiter-Steuerparameter (108) aufweist, mit folgenden Schritten:

Decodieren (110) des codierten Audiosignals unter Verwendung der Informationen über die Tonhöhenverzögerung oder den Tonhöhengewinn, um ein decodiertes Audiosignal (103) zu erhalten;
Filtern (112) des decodierten Audiosignals (103), um ein verarbeitetes Signal (113) zu erhalten, unter Verwendung eines steuerbaren Bass-Nach-Filters (112) mit einer variablen Bass-Nach-Filter-Charakteristik, die durch den Bass-Nach-Filter-Steuerparameter (101) steuerbar ist; und
Einstellen (114) der variablen Bass-Nach-Filter-Charakteristik gemäß dem Bass-Nach-Filter-Steuerparameter (101), der in dem codierten Signal (102) beinhaltet ist,
wobei das steuerbare Bass-Nach-Filter (112) eine Filtervorrichtung (209), die ein Langzeit-Vorhersagefilter (204), eine Gewinnstufe (206), einen Signalmanipulierer (208) aufweist, und einen Subtrahierer (202) zum Subtrahieren einer Ausgabe der Filtervorrichtung (209) von dem decodierten Audiosignal (103) aufweist,
wobei der Bass-Nach-Filter-Steuerparameter (101) einen quantisierten Gewinnwert für die Gewinnstufe (206) oder eine Filtercharakteristikinformation für den Signalmanipulierer (208) aufweist, und
wobei das Einstellen (114) ein Einstellen der Gewinnstufe (206) gemäß dem quantisierten Gewinnwert oder Einstellen des Signalmanipulierers (208) gemäß den Informationen über die Filtercharakteristik aufweist,
wobei das Einstellen ein Decodieren oder Wiedergewinnen der Informationen über eine Tonhöhenverzögerung aufweist, und wobei das Langzeit-Vorhersagefilter (204) gemäß der Tonhöhenverzögerung eingestellt wird,
wobei das Einstellen folgende Schritte aufweist:

Wiedergewinnen (500) des quantisierten Gewinnwerts aus dem codierten Signal, um den Bass-Nach-Filter-Steuerparameter (101) zu erhalten,
Skalieren (504) des Tonhöhengewinns um einen konstanten Faktor, der kleiner ist als 1 und größer als 0, um einen skalierten Tonhöhengewinn zu erhalten; und
Berechnen (506) einer Einstellung der Gewinnstufe unter Verwendung des skalierten Tonhöhengewinns und unter Verwendung des quantisierten Gewinnwerts.

16. Verfahren zum Erzeugen eines codierten Signals (608), das folgende Schritte aufweist:

Erzeugen (600) eines codierten Audiosignals (601) mit Informationen über einen Tonhöhengewinn oder eine Tonhöhenverzögerung aus einem ursprünglichen Audiosignal (603);
Decodieren (602) des codierten Audiosignals, um ein decodiertes Audiosignal zu erhalten;
Berechnen (604) eines Bass-Nach-Filter-Steuerparameters (607), der ein Optimierungskriterium erfüllt, unter Verwendung des decodierten Audiosignals (605) und des ursprünglichen Audiosignals (603); und
Ausgeben (606) des codierten Signals (608) mit dem codierten Audiosignal (601), das die Informationen über den Tonhöhengewinn oder die Tonhöhenverzögerung und den Bass-Nach-Filter-Steuerparameter (607) aufweist,
wobei das Berechnen (604) ferner ein Quantisieren des Bass-Nach-Filter-Steuerparameters auf einen einer vorbestimmten Anzahl von Quantisierungsindizes aufweist, und
wobei der Bass-Nach-Filter-Steuerparameter so berechnet wird, dass das Optimierungskriterium für einen quantisierten Bass-Nach-Filter-Steuerparameter erfüllt ist.

17. Computerprogramm zum Durchführen des Verfahrens gemäß Anspruch 15 oder des Verfahrens gemäß Anspruch 16, wenn dasselbe auf einem Computer oder Prozessor abläuft.

## Revendications

1. Appareil pour traiter un signal codé (110), le signal codé comprenant un signal audio codé présentant des informations sur un retard de hauteur de son, un gain de hauteur de son et un paramètre de commande de filtre de post-traitement de graves (101), comprenant:

un décodeur de signal audio (110) destiné à décoder le signal audio codé à l'aide des informations sur le retard de hauteur de son ou le gain de hauteur de son, pour obtenir un signal audio décodé (103);
un filtre de post-traitement de graves contrôlable (112) pour filtrer le signal audio décodé (103) pour obtenir un signal traité (113), où le filtre de post-traitement de graves contrôlable (112) possède une caractéristique variable de filtre de post-traitement de graves contrôlable par le paramètre de contrôle de filtre de post-traitement de graves (101); et

un moyen de commande (114) destiné à régler la caractéristique de filtre de post-traitement de graves variable selon le paramètre de commande de filtre de post-traitement de graves (101) inclus dans le signal codé (102), dans lequel le filtre de post-traitement de graves contrôlable (112) comprend un appareil de filtration (209) comprenant un filtre de prédiction à long terme (204), un étage de gain (206), un manipulateur de signal (208) et un soustracteur (202) destiné à soustraire une sortie de l'appareil de filtration (209) du signal audio décodé (103),

dans lequel le paramètre de commande du filtre de post-traitement de graves (101) comprend une valeur de gain quantifiée pour l'étage de gain (206),

dans lequel le moyen de commande (114) est configuré pour régler l'étage de gain (206) selon la valeur de gain quantifiée,

dans lequel le moyen de commande (114) comprend un bloc (210) pour décoder ou récupérer les informations sur un retard de hauteur de son et dans lequel le moyen de commande (114) est configuré pour régler le filtre de prédiction à long terme (204) selon le retard de hauteur de son,

dans lequel le contrôleur est configuré pour

récupérer (500) la valeur de gain quantifiée du signal codé pour obtenir le paramètre de commande de filtre de post-traitement de graves (101),

mettre à échelle (504) le gain de hauteur de son par un facteur constant inférieur à 1 et supérieur à 0 pour obtenir un gain de hauteur de son mis à échelle; et

calculer (506) un réglage de l'étage de gain à l'aide du gain de hauteur de son mis à échelle et à l'aide de la valeur de gain quantifiée.

2. Appareil selon la revendication 1,

dans lequel le filtre de de post-traitement de graves contrôlable (112) est configuré pour fonctionner dans un domaine temporel,

dans lequel le manipulateur de signal (208) est mis en oeuvre comme filtre passe-bas, comme filtre passe-tout, comme filtre passe-bande ou comme filtre passe-haut, et

dans lequel le paramètre de commande de filtre de post-traitement de graves comprend, outre une valeur de gain pour l'étage de gain (206), une information de caractéristique de filtre pour le manipulateur de signal (208), et

dans lequel le moyen de commande (114) est configuré pour régler le manipulateur de signal (208) selon les informations sur la caractéristique de filtre.

3. Appareil selon la revendication 1 ou 2,

dans lequel le filtre de post-traitement de graves contrôlable (112) est configuré pour fonctionner dans un domaine spectral,

dans lequel est prévu un premier convertisseur temps-spectre (300) destiné à générer une représentation spectrale du signal audio décodé (103),

dans lequel le filtre de post-traitement de graves contrôlable (112) comprend un deuxième convertisseur temps-spectre (302) destiné à générer des signaux de sous-bande pour différentes sous-bandes et un manipulateur de signal (304) pour chaque sous-bande, dans lequel le manipulateur de signal pour une sous-bande est configuré pour effectuer une opération de pondération à l'aide d'un facteur de pondération (310, 312, 314, 316, 318), et dans lequel des facteurs de pondération individuels (310 à 318) pour les manipulateurs de signal (304) pour des sous-bandes individuelles mettent en oeuvre ensemble une caractéristique de filtre passe-bas, une caractéristique de filtre passe-tout, une caractéristique de filtre passe-bande ou une caractéristique de filtre passe-haut, dans lequel le soustracteur est configuré pour soustraire une sortie d'un appareil de filtration pour une sous-bande d'une sous-bande correspondante générée par le premier convertisseur temps-spectre (300) pour générer un signal de sous-bande soustrait; et

un convertisseur spectre-temps (306) pour convertir les signaux de sous-bande soustraits à un domaine temporel pour obtenir le signal traité (113);

dans lequel le paramètre de commande de filtre de post-traitement de graves comprend une valeur de gain pour l'étage de gain (206) et une information de caractéristique de filtre pour le manipulateur de signal (208).

4. Appareil selon l'une des revendications précédentes,

dans lequel le paramètre de commande de filtre de post-traitement de graves est quantifié par rapport aux informations sur le retard de hauteur de son ou le gain de hauteur de son compris dans le signal audio codé, et

dans lequel le moyen de commande (114) est configuré pour régler la caractéristique de filtre de post-traitement de graves variable selon les informations sur le retard de hauteur de son ou les informations sur le gain de hauteur de son et le paramètre de commande de filtre de post-traitement de graves.

5. Appareil selon la revendication 4,
dans lequel le moyen de commande (114) est configuré pour régler la caractéristique de filtre de post-traitement de graves variable sur base d'un produit des informations sur le retard de hauteur de son ou le gain de hauteur de son et la caractéristique de filtre de post-traitement de graves (506).

6. Appareil selon la revendication 5,
dans lequel le moyen de commande est configuré pour calculer (506) un gain pour l'étage de gain variable (206) à l'aide d'un produit (504) entre le paramètre de commande de filtre de post-traitement de graves et le gain de hauteur de son (502) et un facteur constant inférieur à 1 et supérieur à 0.

7. Appareil selon l'une des revendications précédentes,
dans lequel le filtre de post-traitement de graves contrôlable (112) comprend un filtre de prédiction à long terme (204) et un étage de gain variable (206), dans lequel le filtre de prédiction à long terme (204) est commandé par les informations sur le gain de hauteur de son inclus dans le signal audio codé, et
dans lequel le moyen de commande (114) est configuré pour régler un gain de l'étage de gain variable à l'aide du paramètre de commande de filtre de post-traitement de graves (101) seul ou en combinaison avec les informations sur le gain de hauteur de son.

8. Appareil selon la revendication 7,
dans lequel un filtre passe-bas (208) ou une combinaison d'un convertisseur temps-spectre (302) et d'un pondérateur de sous-bande (304) est connecté à une sortie de l'étage de gain variable (206) ou à une sortie du filtre de prédiction à long terme (204).

9. Codeur pour générer un signal codé (608), comprenant:

un codeur de signal audio (600) destiné à générer un signal audio codé (601) présentant des informations sur un gain de hauteur de son ou un retard de hauteur de son à partir d'un signal audio original (603);
un décodeur (602) destiné à décoder le signal audio codé pour obtenir un signal audio décodé;
un processeur (604) destiné à calculer un paramètre de commande de filtre de post-traitement de graves (607) remplissant un critère d'optimisation à l'aide du signal audio décodé (605) et du signal audio original (603); et
une interface de sortie (606) destinée à sortir le signal codé (608) présentant le signal audio codé (601) comprenant les informations sur le gain de hauteur de son ou le retard de hauteur de son et le paramètre de commande de filtre de post-traitement de graves (607),
dans lequel le processeur (604) comprend par ailleurs un quantificateur (708) destiné à quantifier le paramètre de commande de filtre de post-traitement de graves à l'un d'un nombre prédéterminé d'indices de quantification, et
dans lequel le processeur (604) est configuré pour calculer le paramètre de commande de filtre de post-traitement de graves de sorte que le critère d'optimisation soit rempli pour un paramètre de commande de filtre de post-traitement de graves quantifié.

10. Codeur selon la revendication 9,
dans lequel le processeur (604) est configuré pour calculer le paramètre de commande de filtre de post-traitement de graves (607) de sorte que soit minimisé un rapport signal-bruit entre le signal audio original (603) et un signal audio décodé et filtré par filtre de post-traitement de graves.

11. Codeur selon la revendication 9 ou 10,
dans lequel le processeur (604) comprend un filtre de prédiction à long terme (204), un filtre passe-bas (208) ou un étage de gain (206), et
dans lequel le processeur (604) est configuré pour générer, comme paramètre de commande de filtre de post-traitement de graves (607), un paramètre de retard de hauteur de son, une information de caractéristique de filtre passe-bas ou un réglage d'étage de gain.

12. Codeur selon l'une quelconque des revendications 9 à 11,
dans lequel le quantificateur (708) est configuré pour quantifier le paramètre de commande de filtre de post-traitement de graves en ce qui concerne les informations sur le gain de hauteur de son ou les informations sur le retard de hauteur de son.

**13.** Codeur selon la revendication 12,
dans lequel le quantificateur (708) est configuré pour quantifier le paramètre de commande de filtre de post-traitement de graves à l'aide de l'équation suivante:

$$index = \min\left(2^k - 1, \max\left(0, \frac{2^k - 1}{\alpha_{max} - \alpha_{min}} \cdot \left(\frac{\tilde{\alpha}}{cg_{ltp}} - \alpha_{min}\right)\right)\right),$$

où *index* est le paramètre de commande de filtre de post-traitement de graves quantifié (607), où *min* est une fonction minimale, où *max* est une fonction maximale, où $k$ est le nombre de bits utilisés pour représenter l'indice, où $a_{min}$ est le gain quantifié relatif minimum, où $a_{max}$ est le gain quantifié relatif maximum, où $\tilde{\alpha}$ est le paramètre de commande de filtre de post-traitement de graves non quantifié, où $g_{ltp}$ est l'information sur le gain de hauteur de son, et où c est un facteur constant supérieur à 0 et inférieur à 1.

**14.** Codeur selon l'une des revendications 9 à 13, dans lequel le processeur (604) est configuré pour calculer (910) les valeurs de SNR pour une pluralité de paramètres de commande de filtre de post-traitement de graves quantifiés ou non quantifiés et pour sélectionner (920) le paramètre de commande de filtre de post-traitement de graves quantifié ou non quantifié qui résulte en une valeur de SNR parmi les cinq valeurs de SNR calculées les plus élevées, et
dans lequel l'interface de sortie (606) est configurée pour introduire le paramètre de commande de post-traitement de graves quantifié ou non quantifié sélectionné dans le signal codé (608).

**15.** Procédé de traitement d'un signal codé (110), le signal codé comprenant un signal audio codé présentant des informations sur un retard de hauteur de son, un gain, de hauteur de son et un paramètre de commande de filtre de post-traitement de graves (101), comprenant le fait de:

décoder (110) le signal audio codé à l'aide des informations sur le retard de hauteur de son ou le gain de hauteur de son pour obtenir un signal audio décodé (103);
filtrer (112) le signal audio décodé (103) pour obtenir un signal traité (113) à l'aide d'un filtre de post-traitement de graves contrôlable (112) présentant une caractéristique de filtre de post-traitement de graves variable contrôlable par le paramètre de commande de filtre de post-traitement de graves (101); et
régler (114) la caractéristique de filtre de post-traitement de graves variable selon le paramètre de commande de filtre de post-traitement de graves (101) inclus dans le signal codé (102),
dans lequel le filtre de post-traitement de graves contrôlable (112) comprend un appareil de filtration (209) comprenant un filtre de prédiction à long terme (204), un étage de gain (206), un manipulateur de signal (208) et un soustracteur (202) pour soustraire une sortie de l'appareil de filtration (209) du signal audio décodé (103),
dans lequel le paramètre de commande de filtre de post-traitement de graves (101) comprend une valeur de gain quantifiée pour l'étage de gain (206) ou une information de caractéristique de filtre pour le manipulateur de signal (208), et
dans lequel le réglage (114) comprend le fait de régler l'étage de gain (206) selon la valeur de gain quantifiée, ou de régler le manipulateur de signal (208) selon l'information sur la caractéristique de filtre,
dans lequel le réglage comprend le fait de décoder ou de récupérer les informations sur un retard de hauteur de son et dans lequel le filtre de prédiction à long terme (204) est réglé selon le retard de hauteur de son,
dans lequel le réglage comprend le fait de

récupérer (500) la valeur de gain quantifiée du signal codé pour obtenir le paramètre de commande de filtre de post-traitement de graves (101),
mettre à échelle (504) le gain de hauteur de son par un facteur constant inférieur à 1 et supérieur à 0 pour obtenir un gain de hauteur mis à échelle; et
calculer (506) un réglage de l'étage de gain à l'aide du gain de hauteur de son mis à échelle et à l'aide de la valeur de gain quantifiée.

**16.** Procédé pour générer un signal codé (608), comprenant le fait de:

générer (600) un signal audio codé (601) présentant des informations sur un gain de hauteur de son ou un retard de hauteur de son à partir d'un signal audio original (603);
décoder (602) le signal audio codé pour obtenir un signal audio décodé;
calculer (604) un paramètre de commande de filtre de post-traitement de graves (607) remplissant un critère d'optimisation à l'aide du signal audio décodé (605) et du signal audio original (603); et

sortir (606) le signal codé (608) présentant le signal audio codé (601) comprenant les informations sur le gain de hauteur de son ou le retard de hauteur de son et le paramètre de commande de filtre de post-traitement de graves (607),

dans lequel le calcul (604) comprend par ailleurs le fait de quantifier le paramètre de commande de filtre de post-traitement de graves à l'un d'un nombre prédéterminé d'indices de quantification, et

dans lequel le paramètre de commande de filtre de post-traitement de graves est calculé de sorte que le critère d'optimisation soit rempli pour un paramètre de commande de filtre de post-traitement de graves quantifié.

17. Programme d'ordinateur pour réaliser, lorsqu'il est exécuté sur un ordinateur ou un processeur, le procédé selon la revendication 15 ou le procédé selon la revendication 16.

FIG 1

FIG 2

EP 2 936 484 B1

FIG 3

$$P_{LT}(z) = 1 - \frac{1}{2}z^{-T} - \frac{1}{2}z^{+T}$$

filter apparatus

components in any order or combined

209

103

$\hat{s}(n)$

| LTP PLT filter | | gain stage | 208 | filter $h_{LP}$ |

204    206

T    α    filter charact.

202

$\hat{S}pf(n)$

sub-tractor

+

−

113

$$\widehat{S_{pf}}(n) = \hat{s}(n) - a(\hat{s}(n) * p_{LT}(n) * h_{LP}(n))$$

T, α, filter char. are influenced
by the post-filter control parameter

FIG 4

Retrieve quantized gain value from bit stream — 500

Derive pitch gain — 502

Scale pitch gain — 504

Calculate gain stage setting — 506

FIG 5

FIG 6

EP 2 936 484 B1

EP 2 936 484 B1

FIG 7A

$$SNR_c = 10.\log\left(\frac{\sum_{n=0}^{N-1}(s(n))^2}{\sum_{n=0}^{N-1}(s(n) - \hat{s}(n))^2}\right) \tag{1}$$

$$SNR_{pf}(\alpha) = 10.\log\left(\frac{\sum_{n=0}^{N-1}(s(n))^2}{\sum_{n=0}^{N-1}(s(n) - \hat{s}(n) + \alpha(\hat{s}(n) * p_{LT}(n) * h_{LP}(n=)))^2}\right) \tag{2}$$

$$S_e(n) = (\hat{s}(n) * p_{LT}(n) * h_{LP}(n)) \tag{3}$$

$$\arg\max_{\alpha} SNR_{pf}(\alpha) = \arg\min_{\alpha}\sum_{n=0}^{N-1}(s(n) - \hat{s}(n) + \alpha.S_e(n))^2 \tag{4}$$

$$\tilde{\alpha} = -\frac{\sum_{n=0}^{N-1}(s(n) - \hat{s}(n)).S_e(n)}{\sum_{n=0}^{N-1}(s(n) - \hat{s}(n))^2} \tag{5}$$

$$index = \min\left(2^k - 1, \max\left(0, \frac{2^k - 1}{\alpha_{max} - \alpha_{min}}.\left(\frac{\tilde{\alpha}}{0.5g_{ltp}} - \alpha_{min}\right)\right)\right) \tag{6}$$

$$\alpha(index) = \left(\frac{\alpha_{max} - \alpha_{min}}{2^k - 1}. index + \alpha_{min}\right).0.5g_{ltp} \tag{7}$$

$$index\_new = \arg\max_{index-1, index, index+1} |SNR_{pf}(\alpha(index)) \tag{8}$$

## FIG 7B

Calculate decoded signal — 800

↓

Calculate anti-harmonic component filtered by filter — 810

↓

Calculate optimal gain $\alpha$ — 820

## FIG 8

Calculate SNR for different (non-) quantized parameters — 910

↓

Select (non-) quantized parameter with highest SNR-value — 920

## FIG 9

optimization parameter:   $\alpha$, T, filter char.

FIG 10

FIG 11
(PRIOR ART)

FIG 12
(PRIOR ART)

EP 2 936 484 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012000882 A1